# EUROPÄISCHE PATENTSCHRIFT

(11) **EP 1 473 193 B1**
(45) Veröffentlichungstag und Bekanntmachung des Hinweises auf die Patenterteilung: **27.09.2006**
(21) Anmeldenummer: 04005094.0
(22) Anmeldetag: 04.03.2004
(51) Int. Cl.: B60R 1/12, B60R 11/04, H01L 23/34, H01L 23/427, H05K 7/20

(54) **Kamera**
Camera
Caméra

(30) Priorität: 29.04.2003 DE 10319176
(43) Veröffentlichungstag der Anmeldung: 03.11.2004
(73) Patentinhaber: ROBERT BOSCH GMBH, 70442 Stuttgart (DE)
(72) Erfinder: Kurfiss, Frank, 75417 Muehlacker (DE); Seger, Ulrich, 71229 Warmbronn (DE); Schick, Jens, 71083 Herrenberg (DE); Seekircher, Juergen, 73760 Ostfildern (DE); Eggers, Helmuth, 89077 Ulm (DE); Kurz, Gerhard, 73240 Wendlingen (DE); Wohlgemuth, Thomas, 72631 Aichtal (DE)

(56) Entgegenhaltungen:
- EP-A- 0 934 851
- EP-A- 1 086 859
- DE-A- 10 110 369
- US-A- 5 596 228
- US-A1- 2001 022 553
- US-A1- 2003 010 890
- PATENT ABSTRACTS OF JAPAN Bd. 2000, Nr. 21, 3. August 2001 (2001-08-03) & JP 2001 088611 A (FUJI HEAVY IND LTD), 3. April 2001 (2001-04-03)

## Beschreibung

### Stand der Technik

Die Erfindung betrifft eine Kamera in einem Kraftfahrzeug.

In Kraftfahrzeugen werden vermehrt Kameras zur Gewinnung von Umgebungsinformationen verwendet. Beispielsweise ist geplant, Stereokameras zur Beobachtung des vor dem Kraftfahrzeug befindlichen Straßenraumes zur Objekterkennung und/oder zur Fahrbahnerkennung und/oder zur Abstandsmessung von vorausfahrenden Kraftfahrzeugen einzusetzen. Stereokameras bestehen aus wenigstens zwei Bildsensoren, die im wesentlichen dieselbe Szene aufnehmen. Weiterhin ist vorgesehen, eine oder mehrere Kameras zur Verbesserung der Nachtsicht zu verwenden.

Die Dunkelempfindlichkeit von Bildsensoren von einer Kamera degradiert bei Temperaturerhöhung. Es ist beispielsweise bekannt, dass die Dunkelempfindlichkeit von Bildsensoren aufgrund von erhöhten Leckströmen um einen Faktor 2 degradiert, wenn - in Abhängigkeit der verwendeten Bildsensortechnologie - eine Erhöhung der Temperatur um 5 K - 10 K auftritt. Anderseits wird aus anwendungstechnischen Gründen bei Kraftfahrzeuganwendungen eine Anbringung der Kamera im Bereich des Rückspiegels unter dem Dachhimmel hinter der Windschutzscheibe vorgeschlagen. Diese Anbringung hat beispielsweise den Vorteil, dass die Scheibenwischer eine freie Sicht der Kamera auch bei Regen ermöglichen. Nachteilig ist hierbei jedoch, dass diese Einbauposition der Kamera im Kraftfahrzeug durch eine Einkopplung von solarer Energie und/oder auch durch die Eigenerwärmung der Bildsensoren und der Verstärkerschaltungen zu einer Erwärmung der Kamera führt. Zur Gewährleistung der Funktionsfähigkeit der Kamera ist es wünschenswert, dass eine Abfuhr dieser Wärmeenergie durchgeführt wird. Im allgemeinen ist der Einsatz von aktiven Elementen, wie Lüftern, aus bauraumtechnischen und/oder akustischen und/oder energietechnischen Gründen nicht möglich.

Aus der japanischen Veröffentlichung JP-2001088611 A ist eine Vorrichtung zur Kühlung einer Kamera in einem Kraftfahrzeug bekannt. Es wird vorgeschlagen, eine Luftströmung an einem Chassis vorbeizuleiten, wobei auf dem Chassis zwei Kameras montiert sind. Hinweise auf eine Vorrichtung zur ausreichenden Kühlung der Kamera bei gleichzeitig kompakter Bauweise der Kamera fehlen in der JP-2001088611 A.

### Vorteile der Erfindung

Die nachfolgend beschriebene Kamera in einem Kraftfahrzeug, hat den Vorteil, dass diese eine Vorrichtung aufweist, die zu einer ausreichenden Kühlung der Kamera beiträgt. Durch die Verbindung der wenigstens einen Einrichtung zur Erzeugung von Bildsignalen mit der wenigstens einen Kühleinrichtung über die wenigstens eine Einrichtung zur Wärmeleitung wird in besonders vorteilhafter Weise ermöglicht, dass die wenigstens eine Kühleinrichtung unabhängig von der wenigstens einen Einrichtung zur Erzeugung von Bildsignalen angeordnet werden kann. Hierdurch ist es in vorteilhafter Weise möglich, die wenigstens eine Kühleinrichtung derart anzuordnen, dass die wenigstens eine Luftströmung eine optimale Wärmeabfuhr ermöglicht. Daneben trägt die räumliche Trennung der wenigstens einen Einrichtung zur Erzeugung von Bildsignalen und der wenigstens einen Kühleinrichtung dazu bei, dass beide Einrichtungen für ihre jeweiligen, sehr unterschiedlichen Aufgaben, ohne Berücksichtigung der jeweiligen anderen Einrichtung optimiert werden können. Ein weiterer Vorteil ist, dass der Einsatz von aktiven Elementen zur Kühlung, wie Lüftern und/oder Peltierelementen, möglich, aber zur Erreichung einer ausreichenden Kühlung der Kamera nicht notwendig sind. Zusammenfassend hat die Vorrichtung den Vorteil, dass die Vorrichtung eine ausreichende Kühlung der wenigstens einen Einrichtung zur Erzeugung von Bildsignalen in Verbindung mit einer kompakten Bauweise der Kamera ermöglicht.

Besonders vorteilhaft ist, dass die nachfolgend beschriebene Vorrichtung alternativ oder gleichzeitig zur Kühlung wenigstens eines Kamerabausteins und/oder wenigstens eines Bildsensors und/oder wenigstens eines CMOS-Bildsensors und/oder wenigstens eines CCD-Bildsensors und/oder wenigstens einer Verarbeitungseinheit eingesetzt werden kann.

Vorteilhaft ist, wenn die wenigstens eine Einrichtung zur Wärmeleitung aus einem Material mit einer Wärmeleitfähigkeit von größer 50 W/(m*K) bei in Kraftfahrzeugen üblichen Umgebungstemperaturen besteht, da dies zu einer guten thermischen Kopplung der wenigstens einen Einrichtung zur Erzeugung von Bildsignalen und der wenigstens einen Kühleinrichtung beiträgt. Daneben ist nicht erfindungsgemäss der alternative oder zusätzliche Einsatz wenigstens einer Heatpipe als Einrichtung zur Wärmleitung vorteilhaft. Heatpipes sind derart aufgebaut, dass die Wärmeleitung beispielsweise über eine Kapillarstruktur erfolgt, in der ein Kühlmittel transportiert wird, das Wärme am kühlen Ende der Heatpipe durch Kondensation abgibt. Die Heatpipe hat den Vorteil, dass sie eine thermisch geringe Masse, also eine geringe Wärmkapazität, aufweist.

Durch den Einsatz wenigstens eines Kühlkörpers und/oder wenigstens eines nicht erfindungsgemässen Kühlbleches als Kühleinrichtung erreicht man in vorteilhafter Weise eine gute Wärmeabgabe von der Kühleinrichtung zur umgebenden Luft, da beide Bauteile derart aufgebaut sind, dass sie einen geringen Wärmewiderstand zur umgebenden Luft aufweisen. Als Kühlkörper und/oder Kühlblech kann auch nicht erfindungsgemäss ein Teil des Kameragehäuses herangezogen werden.

In einer nicht erfindungsgemässen Variante der nachfolgend beschriebenen Vorrichtung zur Kühlung einer Kamera in einem Kraftfahrzeug wird die wenigstens eine Kühleinrichtung durch wenigstens einen Teil eines Gehäuses der Kamera und/oder durch wenigstens einen Teil einer Streulichtblende der Kamera gebildet. Dies trägt in besonders vorteilhafter Weise zu einer kompakten und/oder kleinen Bauweise der Kamera und/oder zu einer Verringerung des Gewichtes der Kamera bei. Besonders vorteilhaft ist, wenn wenigstens ein Teil der Streulichtblende der Kamera die wenigstens eine Kühleinrichtung bildet. Im Allgemeinen ist die Luftströmung nahe der Windschutzscheibe am größten. Bei der Montage der Kamera im Bereich der Windschutzscheibe ist die Streulichtblende sehr nahe an der Windschutzscheibe angeordnet. Durch die gleichzeitige Verwendung der Streulichtblende als Kühleinrichtung wird die Kühlung der Kamera hierdurch in besonders vorteilhafter Weise erhöht, da die Luftströmung besonders hoch ist.

Vorteilhaft ist eine Anordnung der wenigstens einen Kühleinrichtung der Kamera derart, dass die wenigstens eine Kühleinrichtung von der direkten Einwirkung von externen Wärmequellen, insbesondere der Sonne, weitgehend geschützt ist. Die Kühlung der wenigstens einen Einrichtung zur Erzeugung von Bildsignalen ist besonders gut, wenn die Temperatur der wenigstens einen Kühleinrichtung möglichst niedrig ist. Besonders vorteilhaft ist daher, wenn die wenigstens eine Kühleinrichtung, insbesondere der wenigstens eine Kühlkörper, bei einer Befestigung der Kamera im Bereich der Windschutzscheibe, auf der scheibenabgewandten Seite der Kamera angebracht ist. Alternativ oder zusätzlich ist es vorteilhaft, wenn die Kamera wenigstens eine Abdeckung mit wenigstens einer Öffnung aufweist, wobei die wenigstens eine Öffnung einen Durchtritt der Luftströmung ermöglicht. Dies trägt in vorteilhafter Weise dazu bei, dass die wenigstens eine Kühleinrichtung unter der wenigstens einen Abdeckung ist und damit beispielsweise von der direkten Sonneneinstrahlung geschützt ist. Gleichzeitig ist bei dieser Variante der Vorrichtung zur Kühlung einer Kamera in einem Kraftfahrzeug die wenigstens eine Kühleinrichtung auch durch die wenigstens eine Luftströmung beaufschlagt.

Besonders vorteilhaft ist eine weitere Variante der nachfolgend beschriebenen Vorrichtung zur Kühlung einer Kamera in einem Kraftfahrzeug, bei der die Kamera im Bereich der Windschutzscheibe befestigt ist. Im Bereich der Windschutzscheibe wird im allgemeinen von der Lüftung und/oder der Klimaanlage des Kraftfahrzeuges eine Luftströmung erzeugt, die in besonders vorteilhafter Weise zur Kühlung der Kamera eingesetzt wird. Insbesondere die Anströmung wenigstens eines Kühlkörpers mit einer Luftströmung, die aus dem Klimastrom und/oder dem Lüftungsstrom entlang der Windschutzscheibe entnommen wird, trägt zu einer kompakten Baugröße der Kamera bei, da insbesondere innerhalb der Kamera keine aktiven Elemente zur Erzeugung einer Luftströmung benötigt werden.

Besonders vorteilhaft ist, wenn die wenigstens eine Einrichtung zur Erzeugung von Bildsignalen und/oder die wenigstens eine Einrichtung zur Wärmeleitung und/oder erfindungsgemäss die wenigstens eine Kühleinrichtung von den weiteren Baugruppen und/oder Bauteilen der Kamera thermisch im wesentlichen isoliert sind, da hierdurch die Kühlung der wenigstens einen Einrichtung zur Erzeugung von Bildsignalen erhöht wird. Gleichzeitig trägt dies dazu bei, dass eine unerwünschte Erwärmung der weiteren Elemente der Kamera verringert wird.

Weitere Vorteile ergeben sich aus der nachfolgenden Beschreibung von Ausführungsbeispielen mit Bezug auf die Figuren und aus den abhängigen Patentansprüchen.

### Zeichnung

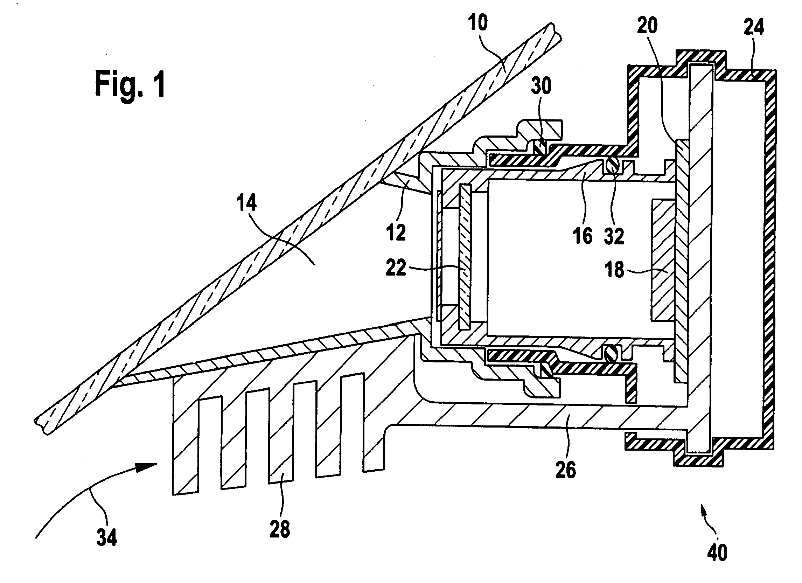

Die Erfindung wird nachstehend anhand der in der Zeichnung dargestellten Ausführungsformen näher erläutert. Die einzige Figur 1 zeigt ein Schnittbild der Seitenansicht der Vorrichtung zur Kühlung einer Kamera in einem Kraftfahrzeug.

### Beschreibung von Ausführungsbeispielen

Nachfolgend wird eine Kamera in einem Kraftfahrzeug beschrieben. Ein Kamerabaustein der Kamera ist über eine thermisch gut leitende Anbindung mit einem extern am Gehäuse gelegenen Kühlkörper verbunden. Der Kühlkörper wird von einer Luftströmung angeströmt, die dem Luftstrom der Klimaanlage und/oder der Lüftung entlang der Windschutzscheibe entnommen wird.

Figur 1 zeigt ein Schnittbild der Seitenansicht der Kamera 40 in einem Kraftfahrzeug des bevorzugten Ausführungsbeispiels, die an einer Windschutzscheibe 10 angebracht ist, mit einer Streulichtblende 12, dem Kamerabaustein 16, der Einrichtung zur Wärmeleitung 26 und dem Kühlkörper 28. Die Kamera 40 ist im Bereich des Innenrückspiegels unterhalb des Dachhimmels im Kraftfahrzeuginneren an der Windschutzscheibe 10 befestigt, wobei der Bilderfassungsbereich der Kamera 40 so ausgerichtet ist, dass die Kamera 40 die Umgebung des Kraftfahrzeuges in Fahrtrichtung erfasst. Die Streulichtblende 12 der Kamera 40 ist durch Klebung an der Windschutzscheibe 10 befestigt, wobei durch die Streulichtblende 12 und die Windschutzscheibe 10 der Bildsensorvorraum 14 gebildet wird. Der Kamerabaustein 16 ist von der scheibenabgewandten Seite von dem Gehäuse 24 bedeckt. Zwischen dem Kamerabaustein 16 und dem Gehäuse 24 befindet sich ein Dichtungsring 32. Über einen zweiten Dichtungsring 30 ist das Gehäuse 24 zusammen mit dem Kamerabaustein 16 mit der Streulichtblende 12 verbunden. Der Kamerabaustein 16 besteht im bevorzugten Ausführungsbeispiel aus einem CMOS-Bildsensor 18, der mit einer Verarbeitungseinheit 20 verbunden ist, sowie den Linsen des optischen Systems 22. Dabei wird die Verarbeitungseinheit 20 im bevorzugten Ausführungsbeispiel zur Signalverstärkung und/oder zur Bildverarbeitung verwendet. Der CMOS-Bildsensor 18 erzeugt in Verbindung mit der Verarbeitungseinheit 20 Bildsignale, die an wenigstens eine nachgeordnete Verarbeitungseinheit elektrisch und/oder optisch und/oder per Funk übertragen werden. Die wenigstens eine nachgeordnete Verarbeitungseinheit ist in Figur 1 nicht eingezeichnet. Der CMOS-Bildsensor 18 und die Verarbeitungseinheit 20 sind thermisch mit einem Ende der Einrichtung zur Wärmeleitung 26 verbunden. Das andere Ende der Einrichtung zur Wärmeleitung 26 ist mit dem Kühlkörper 28 gekoppelt. Im bevorzugten Ausführungsbeispiel bilden die Einrichtung zur Wärmeleitung 26 und der Kühlkörper 28 eine Einheit. Zusammenfassend besteht eine thermisch gut leitende Anbindung des Kamerabausteins 18 (Imagermodul) und der Verarbeitungseinheit 20 an den extern am Gehäuse 24, also an der Außenseite der Kamera, gelegenen Kühlkörper 28. Die Einrichtung zur Wärmeleitung 26 hat dabei die Eigenschaft, dass sie eine gute Wärmeleitung von der Einrichtung zur Erzeugung von Bildsignalen, im bevorzugten Ausführungsbeispiel dem Kamerabaustein 16, zur Kühleinrichtung, im bevorzugten Ausführungsbeispiel dem Kühlkörper 28, ermöglicht. Gleichzeit ist die Einrichtung zur Wärmeleitung 26 so aufgebaut, dass eine Wärmeabgabe zumindest an die weiteren Elemente der Kamera 40 klein ist. Im bevorzugten Ausführungsbeispiel ist die Einrichtung zur Wärmeleitung 26 durch Dichtungen vorzugsweise aus Gummi und/oder durch Kunststoffbefestigungen thermisch von den weiteren Elementen der Kamera im wesentlichen isoliert. Im bevorzugten Ausführungsbeispiel erfolgt die Isolierung durch das Gehäuse 24, das aus Kunststoff ist und an dem die Einrichtung zur Wärmeleitung nach Figur 1 befestigt ist. Die Einrichtung zur Wärmeleitung 26 besteht im bevorzugten Ausführungsbeispiel, wie der Kühlkörper selbst auch, aus einer Aluminiumlegierung. Als alternative oder zusätzliche Materialen werden in weiteren Varianten Aluminium und/oder Kupfer und/oder Kupferlegierungen und/oder Platin verwendet. Allgemein werden für die Einrichtung zur Wärmeleitung 26 und/oder die Kühleinrichtung, beispielsweise den Kühlkörper 28, bevorzugt Materialien mit einer Wärmeleitfähigkeit von größer als 50 W/(m*K) eingesetzt. Diese Forderung wird durch die oben genannten Materialen erfüllt. Die Wärmeabgabe durch den Kühlkörper 28 erfolgt zumindest teilweise durch eine am Kühlkörper 28 vorbeiströmende Luftströmung 34. Die Luftströmung 34 ist im bevorzugten Ausführungsbeispiel die Kühlluft, die durch die Klimaanlage des Kraftfahrzeuges erzeugt wird und die direkt am Kühlkörper 28 vorbeiführt. In einer Variante des bevorzugten Ausführungsbeispiels wird die Luftströmung 34 der Lüftungsanlage des Kraftfahrzeuges verwendet. Zusammenfassend wird die Wärmeenergie vom CMOS-Bildsensor 18 und/oder der Verarbeitungseinheit 20 über die Einrichtung zur Wärmeleitung 26 an das Kühlkörper 28 geleitet und unter Nutzung der Luftströmung 34 der fahrzeugeigenen Klimaanlage und/oder der Lüftungsanlage abgeleitet. In einer nicht erfindungsgemässen Variante wird der Kühlkörper 28 durch das Gehäuse 24 und/oder die Streulichtblende 12 selbst gebildet, insbesondere wird der Kühlkörper 28 aus dem Gehäuse 24 und/oder die Streulichtblende 12 selbst geformt. In einer weiteren Variante des bevorzugten Ausführungsbeispiels ist die Kamera 40 durch wenigstens eine Abdeckung verkleidet, wobei diese Abdeckung wenigstens eine Öffnung aufweist, wobei die wenigstens eine Öffnung einen Durchtritt der Luftströmung und ein Vorbeiströmen an dem wenigstens einen Kühlelement (Kühlkörper 28), das innerhalb der Abdeckung angeordnet ist, ermöglicht. Die Abdeckung ist in Figur 1 nicht eingezeichnet. Durch Spalten als Öffnungen in der Abdeckung (Verkleidung) wird ein Lufteinlass und/oder ein Luftauslass ermöglicht. Eine Verkleidung trägt beispielsweise zu einer Verschönerung der Kamera bei und kann deshalb aus ästhetischen Gründen vorgesehen sein. Im bevorzugten Ausführungsbeispiel besteht der Kühlkörper 28 und/oder die Einrichtung zur Wärmeleitung 26 aus Aluminium und/oder Kupfer. Alternativ oder zusätzlich ist nicht erfindungsgemäss die Verwendung eines Kühlbleches als Kühleinrichtung und/oder als Einrichtung zur Wärmeleitung 26 möglich, wobei das Kühlblech beispielsweise aus Platin besteht.

Die beschriebene Kamera in einem Kraftfahrzeug ist nicht auf eine Kamera beschränkt, die an der Windschutzscheibe eines Kraftfahrzeuges befestigt ist und die einen einzigen Kamerabaustein aufweist. Vielmehr ermöglicht die beschriebene Vorrichtung die Kühlung von Kameras in weiteren Anordnungsmöglichkeiten in einem Kraftfahrzeug. Beispielsweise ist die Vorrichtung auch zur Kühlung wenigstens einer Heckkamera im Bereich der hinteren Heckscheibe und/oder wenigstens einer Kamera im Kühlergrill des Kraftfahrzeuges und/oder wenigstens einer Kamera in den Seitenspiegeln des Kraftfahrzeuges geeignet, wobei in den letzten Anwendungen eine Kühlung durch die Luftströmung des Fahrtwindes stattfindet. Weiterhin ist die Kamera in einer weiteren Variante am Dachhimmel anstatt an der Windschutzscheibe befestigt. Ferner ist die beschriebene Vorrichtung neben der Kühlung wenigstens eines Kamerabausteins (Imagermodul) in Verbindung mit einer Verarbeitungseinheit, wie im bevorzugten Ausführungsbeispiel beschrieben, auch zur Kühlung wenigstens eines CMOS-Bildsensors und/oder wenigstens CCD-Bildsensors und/oder wenigstens einer Verarbeitungseinheit als wenigstens eine Einrichtung zur Erzeugung von Bildsignalen geeignet.

## Patentansprüche

1. Kamera in einem Kraftfahrzeug,
wobei die Kamera (40) wenigstens einen Bildsensor (18) und eine Verarbeitungseinheit (20) aufweist,
wobei wenigstens ein Kühlkörper (28) derart angeordnet ist, dass der Kühlkörper (28) durch wenigstens eine Luftströmung (34) beaufschlagt ist,
wobei der Bildsensor (18) oder die Verarbeitungseinheit (20) über wenigstens eine an einem Gehäuse (24) der Kamera befestigte Einrichtung zur Wärmeleitung (26) mit dem an einer Aussenseite der Kamera gelegenen Kühlkörper (28) thermisch leitend verbunden ist und der Kühlkörper (28) von den weiteren Bauteilen der Kamera (40) thermisch im wesentlichen isoliert ist.

2. Kamera nach Anspruch 1, **dadurch gekennzeichnet, dass** der Kühlkörper (28) entfernt von dem Bildsensor (18) angeordnet ist.

3. Kamera nach einem der vorhergehenden Ansprüche, **dadurch gekennzeichnet, dass** die wenigstens eine Einrichtung zur Wärmeleitung (26) aus einem Material mit einer hohen Wärmeleitfähigkeit, insbesondere mit einer Wärmeleitfähigkeit von größer 50 W/(m*K), besteht.

4. Kamera nach einem der vorhergehenden Ansprüche, **dadurch gekennzeichnet, dass** der Kühlkörper (28) derart angeordnet ist, dass der Kühlkörper (28) von der direkten Einwirkung von externen Wärmequellen, insbesondere der Sonne, weitgehend geschützt ist.

5. Kamera nach einem der vorhergehenden Ansprüche, **dadurch gekennzeichnet, dass** die Kamera (40) im Bereich der Windschutzscheibe (10) befestigt ist, insbesondere dass die Kamera (40) an der Windschutzscheibe (10) befestigt ist.

6. Kamera nach einem der vorhergehenden Ansprüche, **dadurch gekennzeichnet, dass** die wenigstens eine Luftströmung (34) außerhalb der Kamera (40) erzeugt wird, insbesondere dass die wenigstens eine Luftströmung (34) durch die Lüftung des Kraftfahrzeuges und/oder die Klimaanlage des Kraftfahrzeuges erzeugt wird.

7. Kamera nach einem der vorhergehenden Ansprüche, **dadurch gekennzeichnet, dass** wenigstens eine Abdeckung der Kamera (40) wenigstens eine Öffnung aufweist, wobei die wenigstens eine Öffnung einen Durchtritt der Luftströmung (34) ermöglicht und der Kühlkörper (28) innerhalb der Abdeckung angeordnet ist.

## Claims

1. Camera in a motor vehicle,
in which the camera (40) has at least one image sensor (18) and a processing unit (20),
in which at least one heat sink (28) is arranged in such a way that at least one air current (34) is applied to the heat sink (28),
in which the image sensor (18) or the processing unit (20) is connected in a thermally conducting fashion to the heat sink (28) situated on an outer side of the camera via at least one device for conducting heat (26) fastened on a housing (24) of the camera, and the heat sink (28) is substantially thermally insulated from the further components of the camera (40).

2. Camera according to Claim 1, **characterized in that** the heat sink (28) is arranged remotely from the image sensor (18).

3. Camera according to one of the preceding claims, **characterized in that** the at least one device for conducting heat (26) consists of a material with a high thermal conductivity, in particular with a thermal conductivity of greater than 50 W/(m*K).

4. Camera according to one of the preceding claims, **characterized in that** the heat sink (28) is arranged in such a way that the heat sink (28) is largely protected against the direct action of external heat sources, in particular the sun.

5. Camera according to one of the preceding claims, **characterized in that** the camera (40) is fastened in the region of the windscreen (10), in particular **in that** the camera (40) is fastened on the windscreen (10).

6. Camera according to one of the preceding claims, **characterized in that** the at least one air current (34) is produced outside the camera (40), in particular **in that** the at least one air current (34) is produced by the ventilation of the motor vehicle and/or the air conditioning system of the motor vehicle.

7. Camera according to one of the preceding claims, **characterized in that** at least one cover of the camera (40) has at least one opening, the at least one opening enabling passage of the air current (34), and the heat sink (28) being arranged inside the cover.

## Revendications

1. Caméra dans un véhicule à moteur,
la caméra (40) présentant au moins un capteur d'images (18) et une unité de traitement (20), avec au moins un organe de refroidissement (28) disposé de manière à été exposé à au moins un courant d'air (34), dans laquelle
le capteur d'images (18) ou l'unité de traitement (20) est relié(e) de manière thermiquement conductrice par au moins un dispositif de conduction thermique (26), fixé sur un boîtier (24) de la caméra, à l'organe de refroidissement (28) situé sur le côté extérieur de la caméra, l'organe de refroidissement (28) étant essentiellement isolé thermiquement des autres composants de la caméra (40).

2. Caméra selon la revendication 1,
**caractérisée en ce que**
l'organe de refroidissement (28) est éloigné du capteur d'images (18).

3. Caméra selon l'une quelconque des revendications précédentes,
**caractérisée en ce qu'**
au moins un dispositif de conduction thermique (26) est constitué d'un matériau ayant une conductivité thermique élevée, en particulier une conductivité thermique supérieure à 50 W/(m*K).

4. Caméra selon l'une quelconque des revendications précédentes,
**caractérisée en ce que**
l'organe de refroidissement (28) est disposé de manière à être largement protégé de l'action directe de sources de chaleur extrême, en particulier du soleil.

5. Caméra selon l'une quelconque des revendications précédentes,
**caractérisée en ce que**
la caméra (40) est fixée dans la zone d'une pare-brise (10), en particulier sur le pare-brise (10).

6. Caméra selon l'une quelconque des revendications précédentes,
**caractérisée en ce qu'**
au moins un courant d'air (34) est produit à l'extérieur de la caméra (40), en particulier par la ventilation du véhicule à moteur et/ou par le système de climatisation du véhicule.

7. Caméra selon l'une quelconque des revendications précédentes,
**caractérisée en ce qu'**
au moins un recouvrement de la caméra (40) comporte au moins une ouverture permettant un passage du courant d'air (34), l'organe de refroidissement (28) étant disposé à l'intérieur du recouvrement.
